(19) Europäisches Patentamt / European Patent Office / Office européen des brevets

(11) **EP 3 114 713 B1**

(12) **FASCICULE DE BREVET EUROPEEN**

(45) Date de publication et mention
de la délivrance du brevet:
**07.02.2018 Bulletin 2018/06**

(21) Numéro de dépôt: **15713979.1**

(22) Date de dépôt: **05.03.2015**

(51) Int Cl.:
*H01L 31/0224* (2006.01)    *H01L 31/068* (2012.01)
*H01L 31/18* (2006.01)    *H01L 31/0216* (2014.01)

(86) Numéro de dépôt international:
**PCT/FR2015/050540**

(87) Numéro de publication internationale:
**WO 2015/132532 (11.09.2015 Gazette 2015/36)**

(54) **PROCÉDÉ DE RÉALISATION D'UNE CELLULE PHOTOVOLTAÏQUE À DOPAGE SÉLECTIF**

VERFAHREN ZUR ERZEUGUNG EINER FOTOVOLTAISCHEN ZELLE MIT SELEKTIVER DOTIERUNG

METHOD FOR CREATING A PHOTOVOLTAIC CELL WITH SELECTIVE DOPING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.03.2014 FR 1451869**

(43) Date de publication de la demande:
**11.01.2017 Bulletin 2017/02**

(73) Titulaire: **Commissariat à l'Énergie Atomique et aux Énergies Alternatives**
**75015 Paris (FR)**

(72) Inventeurs:
• **LE PERCHEC, Jérôme**
  **38000 Grenoble (FR)**
• **MONNA, Rémi**
  **68640 Muespach le Haut (FR)**

(74) Mandataire: **Cabinet Camus Lebkiri**
**25 rue de Maubeuge**
**75009 Paris (FR)**

(56) Documents cités:
**US-A1- 2009 308 439    US-A1- 2011 139 230**
**US-A1- 2012 152 338    US-A1- 2012 214 270**
**US-A1- 2012 273 040**

## Description

## DOMAINE TECHNIQUE

La présente invention est relative à un procédé de fabrication d'une cellule photovoltaïque présentant un dopage sélectif en surface, telle qu'une cellule à émetteur sélectif ou une cellule à contacts arrières inter-digités.

## ETAT DE LA TECHNIQUE

Une cellule photovoltaïque est un dispositif en un matériau semi-conducteur, tel que le silicium, qui absorbe l'énergie de photons et la convertit en énergie électrique. Schématiquement, ce dispositif comprend une première zone de silicium dopée par des impuretés de type p (par exemple des atomes de bore), en contact avec une deuxième zone de silicium dopée par des impuretés de type n (par exemple des atomes de phosphore), formant ainsi une jonction p-n. La jonction p-n crée un champ électrique, qui dissocie les paires électron-trou générées par l'absorption des photons, les électrons étant dirigés vers la zone n et les trous vers la zone p.

Une jonction p-n peut être réalisée simplement par la formation d'une zone dopée de type n au sein d'un substrat de type p. Des contacts électriques sont en outre formés à la surface du substrat de part et d'autre de la jonction p-n, c'est-à-dire sur la zone dopée n et sur la zone dopée p, pour collecter électrons et trous. Ces contacts sont généralement réalisés par sérigraphie, qui est une technique d'impression rapide et simple à mettre en oeuvre.

Afin d'améliorer la qualité des contacts, une technique consiste à doper fortement la région de semi-conducteur située sous les contacts. Toutefois, une concentration élevée en dopants accroît les pertes par recombinaison Auger, notamment en surface, et donc diminue le rendement de la cellule photovoltaïque. Pour cette raison, ce dopage fort n'est réalisé que localement (i.e. sous les contacts). Une face de la cellule équipée de contacts peut ainsi présenter une concentration en dopants variable.

Un premier exemple de cellules photovoltaïques à dopage modulé en surface est donné par les cellules à émetteur sélectif.

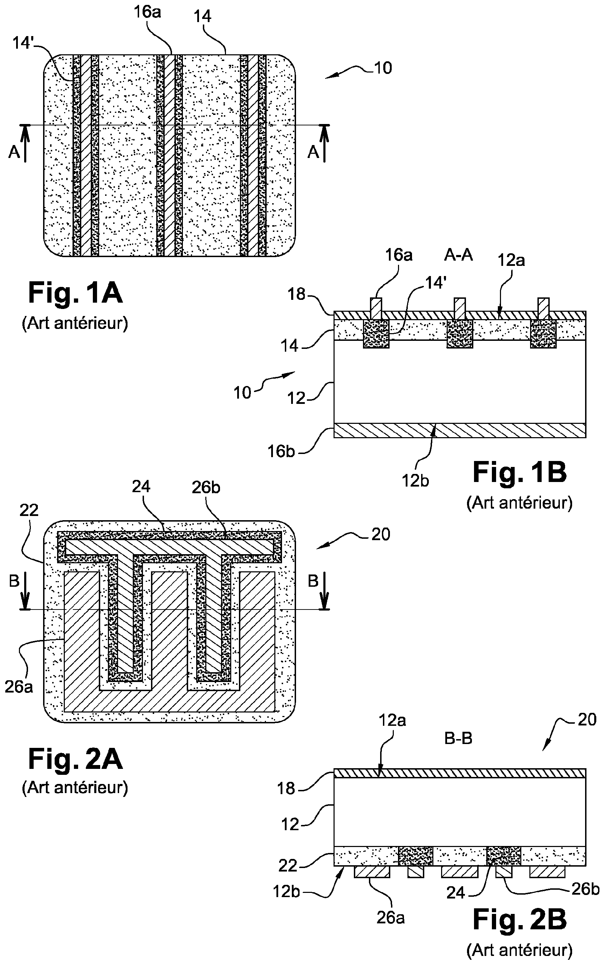

La figure 1A est une vue de dessus schématique d'une cellule photovoltaïque à émetteur sélectif 10 et la figure 1B est une vue en coupe de cette cellule selon l'axe A-A de la figure 1A.

La cellule à émetteur sélectif 10 comporte un substrat 12 en silicium dopé de type p. Le substrat 12 comprend une face avant 12a, exposée au rayonnement solaire, et une face arrière 12b, opposée à la face avant 12a (Fig. 1B). Ainsi, les photons entrent dans la cellule par la face avant 12a du substrat.

Dans cette configuration de cellules photovoltaïques, la jonction p-n est obtenue par la formation d'une couche en silicium 14 dopée de type n en face avant 12a du substrat de type p. La couche 14 est, par exemple, formée par diffusion gazeuse de phosphore (ex. diffusion POCl$_3$) ou par implantation d'atomes ionisés de phosphore dans le substrat. Des régions surdopées 14', ayant une concentration en dopants supérieure à celle de la couche 14, sont en outre réalisées dans la couche 14, par exemple par implantation ionique ou en appliquant un faisceau laser. La couche dopée n 14 et les régions surdopées 14', également de type n, sont appelés « émetteur », par opposition au substrat de type p qui forme une « base » de la jonction p-n.

En face avant 12a du substrat, les zones fortement dopées 14' sont connectées à une première électrode 16a, par exemple sous forme de lignes métalliques (Fig.1A), avec laquelle elles forment un bon contact ohmique en raison de leur faible résistivité. Le dopage plus faible de la couche 14 permet de réduire les recombinaisons de paires électron-trou et de moins écranter les photons incidents de haute énergie. Une deuxième électrode 16b assure le contact en face arrière 12b du substrat.

Enfin, une couche antireflet 18 (non représentée sur la figure 1A) en SiN est disposée sur la face avant 12a du substrat, pour garantir une bonne absorption des photons dans la cellule photovoltaïque.

Ainsi, la cellule à émetteur sélectif 10 présente en face avant deux régions d'un même type de conductivité (ici dopage n), ayant des concentrations en dopants différentes afin d'obtenir des caractéristiques électriques et photovoltaïques distinctes. Les cellules à contacts arrières inter-digités (dites « IBC » pour « Interdigitated back contacts » en anglais) fournissent un deuxième exemple de cellules photovoltaïques ayant une structure de dopage sélectif. Dans cette autre configuration de cellules, la jonction p-n est formée en face arrière d'un substrat de type n (face non éclairée). Cette face arrière comprend deux zones dopées imbriquées ayant des types de dopage opposés : une zone p et une zone n+ pour un substrat type n (la zone n+ ayant un effet de champ répulsif favorable à une moindre recombinaison des porteurs en surface). Ainsi, à l'inverse d'une cellule à émetteur sélectif, une cellule IBC présente, en face arrière, deux zones dopées ayant des types de dopage opposés.

La figure 2A est une vue de dessous simplifiée (face arrière 12b) d'une cellule 20 à contacts arrières inter-digités IBC et la figure 2B est une vue en coupe de cette cellule selon l'axe B-B de la figure 2A.

La cellule IBC 20 comporte en face arrière 12b du substrat en silicium de type n des zones dopées de type n+ 22, c'est-à-dire des zones de type n plus fortement dopées que le substrat 12 (« base »), et des zones dopées de type p 24 (« émetteur »).Les zones 22 et 24 ont une résistivité plus faible que le substrat et servent avantageusement de support aux contacts électriques. Ainsi, des électrodes « n » 26a et « p » 26b sont disposées respectivement en contact avec les zones dopées 22 et 24. Les électrodes 26a et 26b, en forme de peignes entremêlés, recouvrent quasiment toute la face arrière du substrat (Fig.2A). Enfin, une couche antireflet 18 en SiN est disposée sur la face avant 12a du substrat (Fig.2B).

La formation des zones 22 et 24 requiert, par exemple, deux étapes d'implantation ionique, chacune étant réalisée au travers d'un masque spécifique pour définir le motif de la zone implantée (ici un peigne).

Pour la formation de cellules photovoltaïques, le dopage par implantation ionique est souvent préféré aux techniques de dopage par diffusion ou laser, car il permet d'obtenir des émetteurs de meilleure qualité. Cette technique permet en outre de mieux contrôler les profils de dopants dans les émetteurs.

L'article [« High efficiency selective emitter cells using patterned ion implantation », C. E. Dubé et al., Energy Procedia 8, pp. 706-711, 2011] décrit un procédé de réalisation d'une cellule à émetteur sélectif par implantation ionique, à partir d'un substrat en silicium cristallin dopé de type p. Ce procédé comporte les étapes suivantes :

- une première étape d'implantation ionique pour doper la face avant du substrat en totalité ;
- une deuxième étape d'implantation ionique au travers d'un masque pour définir des régions surdopées ;
- un recuit d'oxydation pour former une couche de passivation ;
- le dépôt d'un revêtement antireflet sur la couche de passivation ; et enfin
- une étape de sérigraphie pour former des pistes de métallisation sur les régions surdopées.

Les régions surdopées en face avant du substrat sont difficiles à distinguer optiquement, ce qui rend hasardeux le dépôt des pistes de métallisation sur celles-ci. Pour y remédier, l'auteur de cet article propose de positionner le masque d'implantation et l'écran de sérigraphie par rapport au substrat, en prenant comme référence un bord de ce substrat. Ainsi, les pistes de métallisation et les régions surdopées sont alignées. Néanmoins, une telle référence d'alignement manque de précision et les régions surdopées doivent être suffisamment larges (environ 500 $\mu$m), pour que les pistes de l'électrode puissent être déposées par-dessus de façon certaine.

Le document US2011/0139230 divulgue un autre procédé de fabrication de cellules à émetteur sélectif par implantation ionique, dans lequel l'écran de sérigraphie est positionné par rapport au substrat au moyen de motifs d'alignement préalablement réalisés par laser dans le substrat. Ces motifs d'alignement fins permettent de gagner en précision mais leur formation par laser requiert une étape et un équipement supplémentaires dans le procédé. Un tel procédé de fabrication est donc difficilement exploitable à grande échelle et à moindre coût.

**RESUME DE L'INVENTION**

Il existe donc un besoin de réaliser, de façon simple et économique, une cellule photovoltaïque munie d'une électrode alignée avec précision sur une région semiconductrice fortement dopée.

Selon l'invention, on tend à satisfaire ce besoin en prévoyant les étapes suivantes :

- prévoir un substrat semi-conducteur dopé d'un premier type de conductivité ;
- former dans le substrat une première région dopée, la première région ayant une première concentration d'éléments dopants ;
- former, par implantation ionique d'éléments dopants dans le substrat, au moins un jeu de motifs d'alignement, dont la plus grande des dimensions est inférieure au millimètre, et une deuxième région voisine de la première région, ayant une deuxième concentration d'éléments dopants supérieure à la première concentration ;
- soumettre le substrat à un traitement thermique, de manière à activer les éléments dopants et à former une couche d'oxyde en surface du substrat, par-dessus les motifs d'alignement, la première région et la deuxième région, la deuxième concentration et les conditions du traitement thermique étant choisies de sorte que la couche d'oxyde ait une épaisseur au-dessus des motifs d'alignement supérieure d'au moins 10 nm à l'épaisseur de la couche d'oxyde au-dessus d'une zone du substrat adjacente aux motifs d'alignement ;
- déposer une couche antireflet sur la couche d'oxyde ; et
- déposer, au travers d'un écran, une électrode sur la couche antireflet, en regard de la deuxième région, l'écran étant positionné par rapport au substrat au moyen des motifs d'alignement.

Dans un mode de mise en oeuvre préférentiel, la première région est formée par implantation ionique d'une première dose d'éléments dopants à travers toute une face du substrat.

Les motifs d'alignement et la deuxième région peuvent alors être formés par implantation ionique d'une deuxième dose d'éléments dopants à travers ladite face du substrat superposée d'un masque, d'où il résulte que les motifs d'alignement et la deuxième région cumulent les première et seconde doses.

Les première et seconde doses sont avantageusement comprises entre $5.10^{14}$ cm$^{-2}$ et $2{,}5.10^{15}$ cm$^{-2}$ et sont implantées avec une énergie d'implantation comprise entre 5 keV et 15 keV.

Dans un premier exemple de mise en oeuvre, la cellule photovoltaïque est une cellule photovoltaïque à émetteur sélectif ; ladite face du substrat est une face avant de la cellule photovoltaïque ; la première région est dopée d'un second type de conductivité opposé au premier type, de manière à former une jonction p-n ; et les motifs d'alignement et la deuxième région sont dopés du second type de conductivité.

De préférence, le traitement thermique comprend une unique phase de recuit sous une atmosphère sèche comprenant de l'oxygène, à une température comprise entre 800 °C et 900 °C pendant une durée inférieure à 30min, ou sous une atmosphère humide comprenant de l'oxygène à une température comprise entre 700 °C et 800 °C pendant une durée inférieure à 1 heure.

Dans un deuxième exemple de mise en oeuvre, la cellule photovoltaïque est une cellule photovoltaïque à contacts arrières inter-digités ; ladite face du substrat est une face arrière de la cellule photovoltaïque ; la première région est dopée du premier type de conductivité ; et les motifs d'alignement et la deuxième région sont dopés d'un second type de conductivité opposé au premier type, de manière à former une jonction p-n.

De préférence, le traitement thermique comprend une première phase de recuit sans oxygène à une température comprise entre 950 °C et 1100 °C pendant une durée inférieure à 30 min et une deuxième phase de recuit, soit sous une atmosphère sèche comprenant de l'oxygène à une température comprise entre 800 °C et 900 °C pendant une durée inférieure à une 30 minutes, soit sous une atmosphère humide comprenant de l'oxygène à une température comprise entre 700 °C et 800 °C pendant une durée inférieure à 45 minutes.

Le procédé selon l'invention peut également présenter une ou plusieurs des caractéristiques ci-dessous, considérées individuellement ou selon toutes les combinaisons techniquement possibles :

- la première concentration et les conditions de traitement thermique sont choisies de sorte que la couche d'oxyde ait une épaisseur au-dessus de la première région d'au moins 5 nm ;
- une troisième région ayant le même type de conductivité que la première région est formée dans le substrat à l'opposé de la première région et en même temps que la première région ;
- l'électrode est déposée par sérigraphie et comporte une pluralité de pistes de métallisation réparties sur la couche antireflet ;
- le masque comporte un premier jeu d'ouvertures correspondant à la deuxième région, un deuxième jeu d'ouvertures correspondant aux motifs d'alignement et un troisième jeu d'ouvertures correspondant à des motifs additionnels, lesdits motifs additionnels étant recouverts de plots métalliques lors de l'étape de sérigraphie et servant de mires d'alignement lors d'une étape additionnelle de sérigraphie.

**BREVES DESCRIPTION DES FIGURES**

D'autres caractéristiques et avantages de l'invention ressortiront clairement de la description qui en est donnée ci-dessous, à titre indicatif et nullement limitatif, en référence aux figures annexées, parmi lesquelles :

- les figures 1A et 1B représentent, respectivement en vue de dessus et vue de coupe selon A-A, une cellule à émetteur sélectif selon l'art antérieur ;
- les figures 2A et 2B représentent, respectivement en vue de dessous et vue de coupe selon B-B, une cellule à contacts arrières inter-digités selon l'art antérieur ;
- les figures 3A à 3E représentent des étapes d'un procédé de fabrication d'une cellule photovoltaïque à dopage sélectif selon l'invention ;
- la figure 4 représente la réflectivité dans le spectre visible d'une couche en oxyde $SiO_2$, prise isolément ou en combinaison avec une couche antireflet en SiN, pour différentes épaisseurs de la couche d'oxyde ;
- la figure 5A représente un exemple de masque d'implantation utilisé aux étapes des figures 3A et 3B ;
- la figure 5B représente un autre exemple de masque d'implantation utilisé à l'étape de la figure 3B ;
- la figure 6 représente une cellule à contacts arrières inter-digités obtenue grâce au procédé de fabrication selon l'invention ;
- la figure 7A représente un exemple de motifs d'implantation en face arrière de la cellule à contacts arrières inter-digités de la figure 6 après l'étape de la figure 3B ; et
- la figure 7B représente un exemple de motifs d'électrodes en face arrière de la cellule à contacts arrières inter-digités de la figure 6 après l'étape de la figure 3E.

Pour plus de clarté, les éléments identiques ou similaires sont repérés par des signes de références identiques sur l'ensemble des figures.

**DESCRIPTION DETAILLEE D'AU MOINS UN MODE DE REALISATION**

Dans la description qui suit, on appelle « surdopée » une région d'un substrat semi-conducteur ayant une concentration en éléments dopants supérieure à la concentration en éléments dopants des régions voisines, toutes espèces de dopants confondues.

Il peut notamment s'agir, dans le cas d'une cellule à émetteur sélectif comme celle des figures 1A et 1B, d'une région (réf. 14') dopée d'un type de conductivité ayant une concentration en éléments dopants supérieure à celle de la région adjacente (14) dopée du même type de conductivité. Cela peut être aussi une région dopée d'un premier type de conductivité, ayant une concentration en éléments dopants supérieure à celle de la région adjacente dopée d'un second type de conductivité opposé, comme dans le cas d'une cellule à contacts arrières inter-digités (Figs.2A-B).

Les premier et second types de conductivité opposés désignent bien sûr le dopage de type n et le dopage de type p, ou inversement. Le dopage n consiste à introduire dans un matériau semi-conducteur des éléments dopants (appelés également impuretés dopantes) donneurs d'électrons, tels que des atomes de phosphore, d'arsenic ou d'antimoine pour un substrat en silicium, et le dopage p consiste à introduire des éléments dopants accepteurs d'électrons, tels que des atomes de bore ou de gallium (pour un substrat en silicium).

Dans son état final, une cellule photovoltaïque à dopage sélectif comporte au moins une région surdopée sur laquelle est disposée une électrode. Cette région de fort dopage permet un bon contact ohmique avec l'électrode et ainsi améliore les performances électriques de la cellule.

L'électrode comprend, de préférence, une pluralité de pistes métalliques réparties sur une ou plusieurs régions surdopées. On appelle communément « métallisation » l'étape consistant à former des pistes en métal sur le substrat semi-conducteur d'une cellule photovoltaïque. L'électrode peut être déposée au travers d'un écran, dont les ouvertures correspondent aux différentes pistes métalliques, par toute technique de dépôt appropriée, notamment par sérigraphie.

Afin de faciliter cette étape de métallisation, on prévoit de former, sur la face du substrat destinée à recevoir l'électrode, des mires d'alignement qui serviront de références pour positionner l'écran de sérigraphie. A la différence des procédés de l'art antérieur, les mires d'alignement sont ici formées par implantation ionique, en même temps que la formation de la région surdopée. Grâce à un fort contraste de réflectivité, ces motifs d'alignement sont facilement détectables, pour un positionnement précis de l'écran par rapport au substrat.

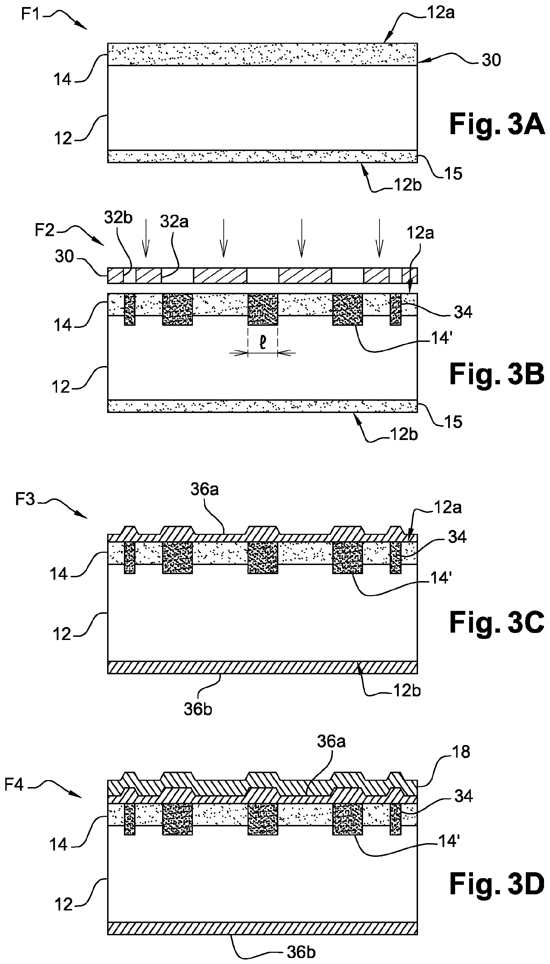

Les figures 3A à 3E représentent des étapes F1 à F5 d'un procédé de fabrication d'une cellule photovoltaïque à dopage sélectif, qui met en oeuvre ces motifs d'alignement formés par implantation ionique.

La cellule est, dans ce premier exemple de mise en oeuvre, une cellule photovoltaïque à émetteur sélectif. Elle est obtenue à partir d'un substrat 12 en un matériau semi-conducteur dopé d'un premier type de conductivité, par exemple un silicium cristallin dopé de type p.

Lors d'une première étape F1 représentée à la figure 3A, une région 14 du substrat 12 est dopée d'un second type de conductivité opposé à celui du substrat, soit de type n. Une jonction p-n 30 est ainsi formée, à l'interface de la région 14 dopée n (appelée l'émetteur) et de la partie restante du substrat 12 dopé p (appelée la base). L'émetteur 14 est ici formé en face avant 12a du substrat, c'est-à-dire sur la face destinée à recevoir le rayonnement solaire une fois la cellule photovoltaïque finalisée.

Comme cela est représenté sur la figure 3A, la région 14 occupe avantageusement toute la face avant 12a du substrat. Doper entièrement la face supérieure du substrat 12 a pour avantage de simplifier l'étape F1, mais également les étapes ultérieures du procédé de fabrication, en particulier la délimitation des régions surdopées (étape F2).

Le dopage de la région 14 peut être obtenu par diverses techniques, notamment la diffusion gazeuse ou l'application d'un laser à la surface du substrat. Toutefois, dans un mode de mise en oeuvre préférentiel, ce dopage est réalisé par implantation d'atomes ionisés à travers la face avant 12a du substrat. L'implantation ionique, par exemple par faisceau d'ions ou par immersion dans un plasma, permet d'obtenir des émetteurs de meilleure qualité électronique et de mieux contrôler le profil de dopants, par rapport au dopage par diffusion. Cela permet également de s'affranchir de l'étape de retrait du verre de phosphore, habituellement pratiquée après une diffusion de phosphore type $POCl_3$.

Les dopants sont, de préférence, implantés avec des énergies d'implantation comprises entre 5 keV et 15 keV, que ce soit en implantation par faisceau d'ions, ou par immersion plasma (par exemple).

Les impuretés dopantes de type n introduites dans le silicium sont, par exemple, des atomes de phosphore. De plus, un masque d'ombrage peut être superposé au substrat pendant l'implantation ionique, lorsqu'un dopage uniforme de la face avant 12a n'est pas souhaité.

La dose D1 d'atomes implantés à l'étape F1 est avantageusement comprise entre $5.10^{14}$ $cm^{-2}$ et $2,5.10^{15}$ $cm^{-2}$. On obtient ainsi une région 14 faisant peu obstacle à l'absorption des photons et dont le taux de recombinaison des porteurs de charge est faible.

Une région 15 peut aussi être dopée de type n en face arrière 12b du substrat (soit à l'opposé de la région 14) lors de la formation de la région dopée 14, notamment lors d'une diffusion gazeuse $POCl_3$. Cette région 15 est sans incidence sur le fonctionnement de la cellule, une fois la métallisation en face arrière réalisée.

Préalablement à l'étape F1, le substrat 12 peut avoir subi des étapes de préparation de sa surface, notamment une étape de nettoyage de sa face avant 12a et sa face arrière 12b, suivie d'une étape de structuration de sa face avant 12, par exemple sous forme de pyramides. Cette structuration a pour but d'augmenter par diffraction la proportion des photons qui pénètrent dans le substrat. Ces étapes de préparation étant classiques, elles ne sont pas décrites en détail ici.

A l'étape F2 de la figure 3B, une nouvelle étape de dopage, par implantation ionique, est effectuée au travers d'un masque d'ombrage 30. Au moins une région surdopée 14', adjacente à la région 14, et deux motifs d'alignement 34 sont définis lors de cette étape dans la face avant 12a du substrat. La région surdopée 14' et les motifs d'alignement 34 ont une concentration en dopants C2 supérieure à la concentration en dopants C1 de la région 14.

A titre d'exemple, trois régions surdopées 14' et deux mires d'alignement 34, de part et d'autre des régions 14', sont représentées sur la figure 3B. Toutes sont entourées de la région 14 plus faiblement dopée.

Les ions implantés lors de l'étape F2 appartiennent, dans ce premier exemple de mise en oeuvre, au même type de conductivité que celui de la région 14 (type n). Les régions 14' forment ainsi un émetteur dits sélectif, destiné à être recouvert par les pistes de métallisation.

Lorsque la face avant 12a a été entièrement dopée à l'étape F1 (Fig.3A), la dose D2 d'ions implantés à l'étape F2 peut être égale, inférieure ou supérieure à la dose d'implantation D1 de l'étape F1. Les régions surdopées 14' et les motifs d'alignement 34 sont alors formés au sein de la couche 14 et présentent une concentration en dopants correspondant à la somme des doses D1 et D2. Il n'y a, dans ce cas, pas de contraintes fortes pour le placement du masque d'ombrage 30 par rapport au substrat 12.

Une dose d'implantation D2 égale à la dose d'implantation D1 simplifie le procédé et améliore sa reproductibilité. Un même équipement d'implantation, configuré avec les mêmes paramètres, est utilisé pour les étapes F1 et F2.

Lorsqu'au contraire les régions fortement dopées 14' sont implantées en dehors de la région faiblement dopée 14, c'est-à-dire dans des zones du substrat initial 12 dopées de type p, la dose d'implantation D2 est alors supérieure à la dose D1, de sorte qu'on obtienne une concentration en dopants plus importante. On prévoit alors deux masque d'ombrage 30 différents (i.e. complémentaires) pour les étapes d'implantations F1 et F2.

Les étapes F1 et F2 peuvent être effectuées dans n'importe quel ordre, étant donné que la concentration en dopants C2 des régions 14' résulte, soit de l'addition des dopants de l'étape F1 et des dopants de l'étape F2, soit d'une unique étape d'implantation F2 réalisée indépendamment de l'étape F1.

Le masque d'ombrage 30 est, de préférence, situé à une distance comprise entre 0 et 5 mm du substrat 12 et positionné parallèlement à celui-ci. Il comporte un premier jeu d'ouvertures 32a dont les formes et dimensions correspondent à celles des régions 14' et un deuxième jeu d'ouvertures 32b correspondant aux motifs d'alignement 34. Ces ouvertures sont, par exemple, réalisées par perçage laser.

De préférence, les régions surdopées 14' forment à la surface du substrat des lignes dont la dimension transverse (la largeur l dans le plan de coupe de la figure 3B) est comprise entre 250 $\mu$m à 300 $\mu$m pour des cellules silicium à émetteur sélectif.

Le masque 30 est un masque d'ombrage amovible et peut être formé de divers matériaux, notamment en silicium, en graphite ou en métal, éventuellement recouvert d'une pellicule de protection non-métallique, par exemple en résine ou en un matériau diélectrique amorphe. Il peut aussi s'agir d'un masque « stencil » comme ceux employés sur les équipements de sérigraphie.

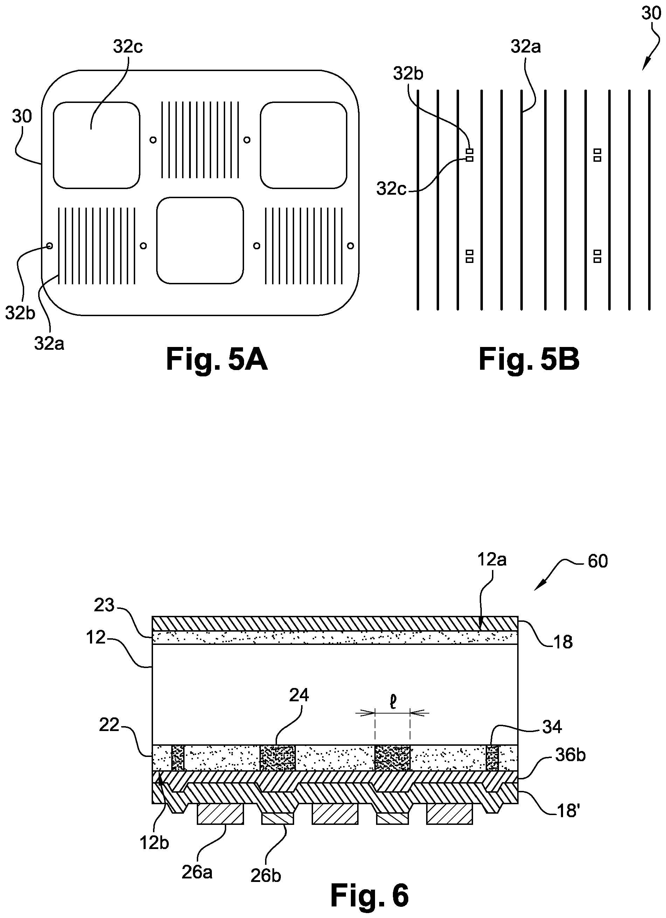

La figure 5A représente un exemple de masque d'ombrage 30 « composite » pouvant servir à la fois pour l'implantation ionique de l'étape F1 et l'implantation ionique de l'étape F2. Ce masque d'ombrage comprend deux séries de motifs identiques, pour traiter plusieurs substrats simultanément. Les motifs de la première série comprennent chacun une ouverture unique 32c destinée à l'implantation de dopants sur toute la surface du substrat (« pleine plaque »), lors de l'étape F1 (dose D1). Les motifs de la deuxième série correspondent aux ouvertures 32a et 32b de la figure 3B, pour former respectivement les régions surdopées et les motifs d'alignement, lors de l'étape d'implantation F2 (dose D2).

Ce masque est avantageusement utilisé pour la fabrication d'un lot regroupant plusieurs cellules photovoltaïques, dans l'optique d'une production industrielle à grande échelle. Un premier groupe de cellules est implanté à l'aide de la première série de motifs, tandis qu'un deuxième groupe des cellules est implanté avec la deuxième série de motifs. Les motifs sont ensuite décalés d'un cran, horizontalement ou verticalement, puis on procède à la deuxième implantation avec l'autre série de motifs pour chaque groupe, sans qu'on ait besoin d'extraire les substrats de la chambre d'implantation entre les deux implantations ioniques.

La figure 3C représente une étape F3 de traitement thermique, permettant d'une part d'activer électriquement les dopants des régions 14, 14', des motifs 34, et d'autre part, d'oxyder la surface du substrat 12. Une couche d'oxyde 36a recouvre alors la face avant 12a comprenant la région dopée n 14, les régions surdopées n 14' et les motifs d'alignement 34. De préférence, une couche d'oxyde 36b recouvre également la face arrière 12b du substrat. Le matériau semi-conducteur étant ici du silicium, les couches 36a et 36b sont en oxyde de silicium, par exemple en $SiO_2$. De préférence, l'épaisseur des couches 36a et 36b est supérieure à 5 nm et inférieure à 40 nm.

Le traitement thermique comporte avantageusement une première phase d'activation des dopants à une température T1 et une deuxième phase sous un flux partiel d'oxygène à une température T2 permettant de former les couches d'oxyde 36a et 36b. En dissociant ainsi les deux actions du traitement thermique, on peut choisir des conditions de recuit différentes pour ces deux actions et optimiser chacune d'elles. Les températures (T1, T2) et/ou les durées de recuit peuvent notamment être différentes. A titre d'exemple, la température d'activation T1 des dopants est comprise entre 800 °C et 1100 °C et la températured'oxydation T2 est comprise entre 700 °C et 900 °C.

Alternativement, le traitement thermique de l'étape F3 peut comprendre une seule phase de recuit, sous une atmosphère comprenant de l'oxygène, qui réalise à la fois l'activation des dopants et la croissance des couches d'oxyde 36a et 36b.

L'épaisseur de la couche d'oxyde de silicium formée sur la face avant 12a du substrat dépend bien sûr des conditions du recuit oxydant : la durée du recuit, la température et le débit d'oxygène principalement. La concentration en dopants du matériau oxydé influe également sur l'épaisseur d'oxyde. Ainsi, à conditions de recuit identiques, l'oxyde est d'autant plus épais que la concentration en dopants (toutes espèces confondues) est élevée. On notera par ailleurs que pour une dose et une énergie données, la technique d'immersion plasma permet d'implanter les dopants plus près de la surface par rapport à l'implantation par faisceau d'ions, ce qui permet de faire croître un oxyde plus épais.

Comme la face avant 12a présente des concentrations en dopants C1 et C2 différentes, la couche d'oxyde 12a a une épaisseur variable. Celle-ci est plus épaisse au-dessus des motifs d'alignement 34 et des régions surdopées 14', comme cela est représenté sur la figure 3C.

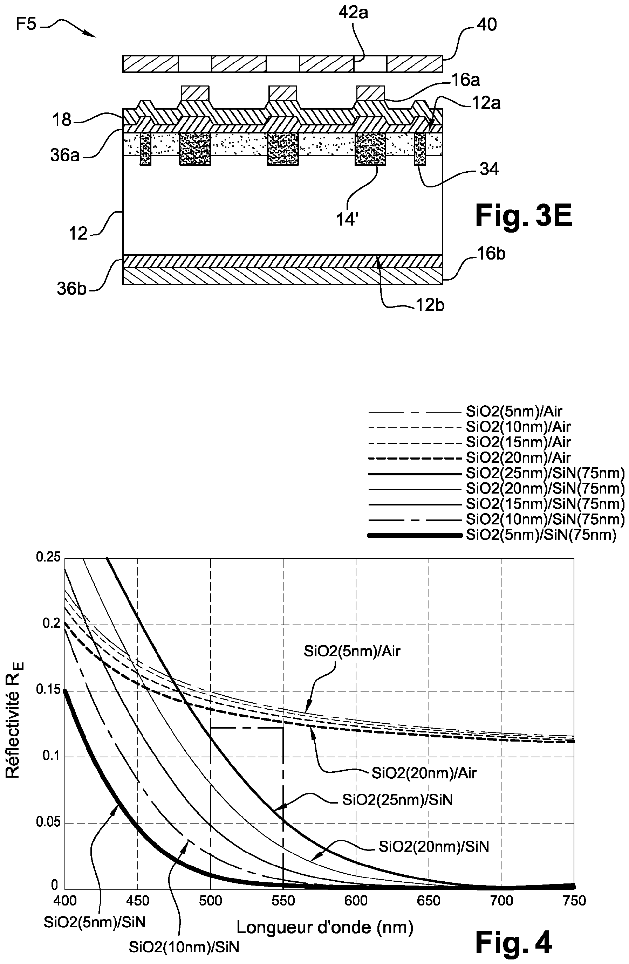

La figure 4 représente, dans une première série de courbes en traits pointillés, la réflectivité $R_E$ dans la gamme du visible (400-750 nm) d'un substrat en silicium dont la surface présente une texturation pyramidale classique et recouvert d'une seule couche en oxyde de silicium $SiO_2$, pour des épaisseurs de cette couche allant de 5 nm à 20 nm (par pallier de 5 nm).

On constate que plus l'oxyde $SiO_2$ est épais, plus la réflectivité $R_E$ est faible, autrement dit moins le substrat réfléchit la lumière incidente. Ce constat est d'ailleurs vrai quelle que soit la longueur d'onde de la lumière incidente. Par conséquent, un contraste de réflectivité naît de la différence d'épaisseur entre l'oxyde 36a sur les motifs d'alignement 34 et les régions 14' d'une part, et l'oxyde 36a sur la couche 14 d'autre part.

Ce contraste est défini par la relation suivante :

$$ C = \frac{R_{E1} - R_{E2}}{R_{E1} + R_{E2}} $$

dans laquelle $R_{E1}$ désigne la réflectivité des motifs d'alignement 34 et $R_{E2}$ désigne la réflectivité de la région dopée adjacente 14.

Les courbes en pointillés de la figure 4 sont rapprochées. De fait, le contraste de réflectivité dû à une seule couche d'oxyde d'épaisseur variable est très faible, inférieur à 5 % environ. C'est pour cette raison qu'il est difficile de distinguer à l'oeil nu des régions fortement dopées parmi des régions plus faiblement dopées.

Pour augmenter le contraste optique entre les régions du substrat correspondant aux motifs d'alignement 34 et la région 14 immédiatement adjacente, une couche antireflet 18, par exemple en SiN, est déposée sur la couche d'oxyde 36a lors d'une étape F4 (Fig.3D). Cette couche antireflet 18 est couramment utilisée dans les cellules photovoltaïques, car elle permet d'augmenter le nombre de photons absorbés par les cellules (elle diminue la réflectivité de l'émetteur 14). Toutefois, en plus de jouer ce rôle dans la cellule à émetteur sélectif 30, les inventeurs ont remarqué que cette couche antireflet avait également pour effet d'accentuer la différence de réflectivité $R_{E1}$- $R_{E2}$ causée par une épaisseur d'oxyde variable.

Sur la figure 4, une deuxième série de courbes en traits pleins montre les réflectivités pour différentes épaisseurs de couche d'oxyde (de 5 à 25 nm, par pallier de 5 nm), chacune étant désormais recouverte d'une couche antireflet en SiN de 75 nm d'épaisseur. On constate d'une part que l'écart entre deux courbes est bien plus important lorsqu'une couche d'antireflet en SiN est superposée à la couche d'oxyde en $SiO_2$. Par conséquent, le contraste visuel C est amplifié grâce à la couche antireflet 18. D'autre part, l'évolution de la réflectivité $R_E$ avec l'épaisseur de la couche d'oxyde $SiO_2$, en présence de la couche en SiN, est inversée par rapport à la situation précédente (i.e. sans la couche SiN) : plus l'oxyde $SiO_2$ est épais, plus la réflectivité $R_E$ est forte, autrement dit plus le substrat réfléchit la lumière incidente.

A titre d'exemple, dans la plage de longueurs d'onde 500-550 nm correspondant à la couleur verte, le contraste de réflectivité C est égal à 48 % environ entre une couche de $SiO_2$ de 5 nm d'épaisseur et une couche de 10 nm d'épaisseur, toutes deux étant recouvertes d'une couche d'antireflet en SiN de 75 nm d'épaisseur. Le contraste C est égal à 70 % pour des couches d'oxyde de 5 nm et 15 nm d'épaisseur, à 37 % entre 10 nm et 15 nm d'épaisseur et à 58 % entre 10 nm et 20 nm.

En procédant à différents calculs du contraste optique C, il peut être mis en évidence qu'une différence d'au moins 10 nm d'épaisseur entre deux couches de $SiO_2$ permet d'atteindre un contraste de réflectivité particulièrement élevé (en présence de la couche antireflet), supérieure à 50%. Or, comme cela a été décrit précédemment, l'épaisseur de la couche d'oxyde dépend des conditions du recuit d'oxydation, mais également de la concentration en dopants. Les conditions du recuit d'oxydation à l'étape F3 et la concentration en dopants C2 implantés dans les motifs d'alignement 34 à l'étape F2 seront donc choisies de sorte à obtenir une différence d'épaisseur d'au moins 10 nm entre la portion d'oxyde 36a située au-dessus des motifs d'alignement 34 et la portion située en dehors de ces motifs, par exemple au-dessus de la région faiblement dopée 14 (Fig.3C). Les motifs d'alignement 34 pourront ainsi être détectés facilement à la surface du substrat, sans avoir recours à des systèmes d'imagerie complexes, type infrarouge par exemple.

Le choix de la concentration en dopants C2 dans l'émetteur sélectif 14' et les motifs d'alignement 34 est donc motivé par le besoin d'obtenir dans ces régions (en plus d'une résistivité faible pour réaliser un bon contact ohmique) une couche d'oxyde plus épaisse, de 10 nm au moins, par rapport à la région qui entoure les motifs d'alignement (la région 14 dopée n ou le substrat 12 dopé p lorsque les motifs sont implantés en dehors de la couche 14).

De préférence, le traitement thermique comprend une seule phase de recuit réalisant l'activation des dopants et l'oxydation thermique. Les conditions d'un tel recuit pour l'obtention de la couche d'oxyde 36a sont les suivantes :

- le recuit est réalisé en présence d'oxygène sec (mélange d'oxygène et d'azote en phase gazeuse) et sa durée est inférieure à 30 min ;
- la température du recuit est comprise entre 800 °C et 900 C, par exemple 850 C ;
- le débit d'oxygène, pendant la phase d'oxydation, est compris entre 10 à 50 litres par minute, le ratio oxygène/azote allant de 0,2 à 1.

Alternativement, le traitement thermique est réalisé en une seule étape de recuit sous une atmosphère humique (i.e. comprenant de la vapeur d'eau) entre 700 °C et 800 °C pendant une durée inférieure à 1 heure.

La dose d'implantation D2 lors de l'étape F2 est avantageusement comprise entre $5^E14$ et $2,5^E15$ atomes/cm$^2$, et préférentiellement entre $1^E15$ et $2,5^E15$ atomes/cm$^2$. On estime que la concentration d'atomes C2 qui en résulte est comprise entre $1^E20$ et $1^E22$ atomes/cm$^3$, en surface des zones 14'/34 (sur 25 nm de profondeur environ).

Le choix de la concentration en dopants C1 dans la région faiblement dopée 14 est, pour sa part, contraint par la nécessité de limiter les recombinaisons de type Auger dans la cellule photovoltaïque, car cette région forme la majeure partie de l'émetteur.

Lorsque le dopage F1 est réalisé par diffusion gazeuse, la concentration C1 en surface (i.e. sur les 25 premiers nm) est, de préférence, comprise $5^E19$ et $1^E21$ atomes/cm$^3$ (elle varie selon la position sur la plaquette, les paramètres de diffusion et selon le type de dopant). Lorsque l'étape F1 est réalisée par implantation ionique, la dose implantée D1 est avantageusement comprise entre $5^E14$ et $2,5^E15$ at/cm$^2$, et préférentiellement entre $1^E15$ et $2,5^E15$ atomes/cm$^2$.

De façon plus générale, on peut considérer qu'un rapport C2/C1 des concentrations en surface (i.e. dans les 25 premiers nm) supérieur ou égal à 1,5 permet d'obtenir la différence d'épaisseur d'oxyde de 10 nm (au moins) requise pour distinguer les motifs d'alignement 34.

Dans la détermination de la concentration C1 et/ou des paramètres du traitement thermique, il peut être tenu compte du fait que la couche d'oxyde 36a au-dessus de la région 14 devrait, de préférence, avoir une épaisseur d'au moins 5 nm. Cette épaisseur minimale d'oxyde garantit que la surface du substrat dans cette région est suffisamment passivée. En effet, outre le fait que la couche d'oxyde 36a révèle les motifs d'alignement 34, elle agit également comme couche de passivation de la surface du substrat 12. Dans les conditions du recuit et pour les gammes de dose/concentration C1 indiquées ci-dessus, la couche d'oxyde 36a possède une épaisseur au-dessus de la région faiblement dopée 14 supérieure à 5 nm.

La couche antireflet 18 est formée d'un matériau ayant un indice optique supérieur à celui de l'oxyde (supérieur à 1,5 dans le cas du SiO$_2$), par exemple SiN, SiON, TiO$_2$ ou Al$_2$O$_3$. Son épaisseur est optimisée pour que les régions 14 (régions non recouvertes par le métal) absorbent un maximum de photons. Cette épaisseur est, de préférence, comprise entre 50 nm et 100 nm. Alternativement, l'antireflet 38 peut être formé d'une couche composite d'indice moyen supérieur à celui de l'oxyde, c'est-à-dire un empilement de plusieurs couches dont la hauteur totale ne dépasse pas 150 nm, par exemple SiN/SiON (la couche SiON étant dirigée vers l'extérieur de la cellule).

Une fois la couche d'antireflet 18 déposée (Fig.3D), les motifs d'alignement 34 apparaissent clairement à la surface du substrat. On peut alors procéder à l'étape F5 de formation des électrodes, en face avant et en face arrière du substrat.

Dans un mode de mise en oeuvre préférentiel représenté à la figure 3E, cette étape F5 est réalisée par sérigraphie, selon le principe du pochoir. Des pistes de métallisation 16a sont déposées sur la couche d'antireflet 18, en regard des régions surdopées 14' (i.e. l'émetteur sélectif), au moyen d'un écran de sérigraphie 40. Cet écran comporte des ouvertures 42a correspondant au motif de l'électrode à former, par exemple de longues lignes étroites et parallèles entre elles.

L'écran 40 est positionné au-dessus du substrat 12 de sorte que les ouvertures 42a viennent en regard des régions 14' du substrat. Ce positionnement de l'écran 40 est réalisé à l'aide des motifs d'alignement 34, rendus visibles grâce à la couche d'oxyde 36a et la couche antireflet 18. Le positionnement peut d'ailleurs être automatisé, grâce à un repérage visuel des motifs d'alignement au moyen d'une caméra (l'écran est positionné automatiquement après que la caméra a repéré les mires 34). Les équipements de sérigraphie sont généralement équipés d'une telle caméra dans le domaine visible.

Une pâte de sérigraphie est étalée sur la couche antireflet 18 à travers l'écran 40 posé sur le substrat, formant les pistes de métallisation 16a de la figure 3E. La pâte de sérigraphie est un mélange comprenant, de préférence, des microparticules métalliques, par exemple en argent ou en aluminium, de la frite de verre, un liant organique et un solvant. Puis, dans une étape ultérieure du procédé de fabrication (non représentée), le substrat est soumis à un recuit infrarouge. Lors de cette étape, la pâte de sérigraphie migre à travers les fines couches d'oxyde 36a et d'antireflet 18, et prend contact sur les régions surdopées 14'.

Une métallisation 16b est également réalisée en face arrière 12b du substrat. Par exemple, une seconde pâte de sérigraphie est déposée pleine plaque sur la couche d'oxyde 36b préalablement formée. Comme pour les pistes de métallisation 16a, la métallisation 16b perfuse à travers la couche d'oxyde. Après le recuit infrarouge, elle forme l'électrode métallique en contact ohmique avec le substrat 12 de type p.

Dans le cas des cellules à émetteur sélectif, les pistes de métallisation 16a (et donc les ouvertures 42a correspondantes) ont, de préférence, une largeur inférieure à 100 μm. Les pistes métalliques 16a sont encore plus fines que les lignes surdopées 14', pour parer aux incertitudes d'alignement - les lignes 14' faisant par exemple 250 μm de large. En outre, la plus grande des dimensions des motifs d'alignement (et donc des ouvertures 42b correspondantes) est inférieure à 1 mm, et avantageusement inférieure à la largeur des régions surdopées 14' (< 250-300 μm). Des motifs d'alignement 34 aussi fins garantissent un positionnement précis de l'écran 40 par rapport au substrat 12. C'est ainsi qu'on peut déposer à coup sûr des pistes de métallisation 16a recouvrant partiellement les zones surdopées 14'. Les pistes de métallisation 16a ne s'étendent pas en dehors des zones surdopées 14' et sont, au contraire, centrées au-dessus de celles-ci.

Les motifs d'alignement 34 sont préférentiellement situés dans une zone de la surface du substrat commençant à mi-distance du centre de la plaquette (dans le cas d'un substrat circulaire) et s'arrêtant peu avant le bord extérieur de la plaquette. Ce placement des motifs 34 permet d'être plus précis sur l'alignement de l'écran de sérigraphie 40. Ainsi, on évitera de réaliser les motifs 34 sur l'extrême bord de plaquette où les doses d'implantation et l'épaisseur d'oxyde sont moins bien contrôlées.

La formation de l'électrode supérieure, i.e. du côté de l'émetteur, peut comprendre deux étapes de sérigraphie successives (sérigraphies connues sous le nom de « double print » et « dual print »). Par exemple, une première étape vise à former les pistes de métallisation 16a sur les régions surdopées 14' et une seconde étape vise à former des pistes de connexion transverses, qui relient électriquement les pistes 16a.

La figure 5B représente un exemple de masque d'implantation 30 dans ce cas de « double » sérigraphie. Le masque 30 utilisé peut comporter, en plus des ouvertures 32a (correspondant aux régions surdopées) et 32b (mires d'alignement pour aligner la première étape de métallisation avec un écran 40), un jeu d'ouvertures additionnel 32c pour former des motifs additionnels. Ces motifs additionnels sont destinés à recevoir des plots métalliques servant à leur tour de mires d'alignement lors de la seconde étape de métallisation. A cet effet, l'écran 40 contient alors des ouvertures supplémentaires correspondant à ces plots métalliques. Les plots métalliques ne sont pas en contact avec le coeur du substrat car les régions implantées 14' sont profondes et ainsi ils n'agiront pas comme centre recombinant parasite pour les photo-porteurs.

Le procédé de fabrication décrit ci-dessus en relation avec une cellule à émetteur sélectif convient également à la formation d'une cellule à contacts arrières inter-digités. Le procédé est mis en oeuvre en face arrière du substrat, plutôt qu'en face avant, et permet la formation d'une ou plusieurs régions surdopées d'un type de conductivité opposé à celui d'une région voisine faiblement dopé.

La figure 6 représente une cellule photovoltaïque 60 de type IBC (« Interdigitated back contacts » en anglais) obtenue dans un deuxième exemple de mise en oeuvre du procédé de fabrication.

Considérons dans cet exemple un substrat en silicium 12 dopé de type n, par exemple en phosphore. Une région 22 de la face arrière 12b est d'abord dopée de type n+, i.e. plus fortement que le substrat 12 de type n, formant la base de la cellule (dopage renforcé en phosphore par exemple). De préférence, la région 22 occupe la face arrière 12b en totalité et forme une couche dopée n+ en surface du substrat 12.

De préférence, une région dopée de type n+ 23 est également présente en face avant 12a du substrat 12. Généralement moins dopée que la région 22 (mais plus que le substrat 12), la région 23 crée un champ répulsif favorable à une moindre recombinaison des porteurs en surface du substrat, au même titre que la couche 22. Les flancs latéraux du substrat peuvent également être dopés n+ pour la même raison.

Le dopage n+ des régions 22 et 23 peut être réalisé par exemple par diffusion $POCl_3$ (suivi d'un retrait du verre de phosphore) sur tout le pourtour du substrat (y compris aux flancs), ou par implantation d'atomes ionisés de phosphore ou d'ions composés de type phosphore-hydrogène ($PH+$, $PH^{2}+$...) sur chaque face du substrat (étape F1).

Au moins une région surdopée 24 et des motifs d'alignement 34, tous dopés de type p (dopage opposé à celui du substrat 12, par exemple avec des atomes ionisés de bore ou avec des ions composés de type bore-hydrogène ou bore-fluor) sont ensuite formés par implantation ionique, au moyen d'un masque d'ombrage (étape F2).

La jonction p-n est alors formée et la région surdopée 24 forme l'émetteur de la cellule IBC 60. La région surdopée 24 de type p peut être adjacente à la région 22 de type n, comme cela est illustré sur la figure 6, c'est-à-dire attenante à la région 22, ou séparée de la région 22 d'une faible distance. En effet, une portion du substrat laissée intacte entre les deux régions permet d'améliorer certaines performances électriques de la cellule photovoltaïque. L'écart entre la région dopée 22 et la région surdopée 24 vaut par exemple entre 200 nm à 300 nm, les régions 22 et 24 pouvant être larges de 0,5 mm à 1,5 mm.

La région 24 est, de préférence, formée dans la couche 22 dopée de type n. Une région surdopée peut donc être, dans le cas d'une cellule IBC, une région d'un premier type de conductivité formée au sein d'une région d'un second type de conductivité opposé, de telle sorte que le premier type « contre-balance » le second type. Cette région surdopée cumule alors les dopants du premier type et les dopants du second type.

Dans l'exemple de cellule IBC représenté en vue en coupe sur la figure 6, deux régions surdopées 24 sont formées dans la couche 22. De préférence, la largeur l de l'émetteur (régions 24) est comprise entre 500 μm et 2 mm.

Le traitement thermique de l'étape F3 permet d'activer les dopants de type n de la région 22 et les dopants de type p de la région 24. Au moins une partie de ce traitement thermique est réalisée sous oxygène, pour former en face arrière 12b une couche d'oxyde 36b d'épaisseur variable, avec une différence d'au moins 10 nm entre la portion d'oxyde recouvrant les motifs 34 et la portion d'oxyde recouvrant la région faiblement dopé 22.

La température du recuit d'activation est, de préférence, comprise entre 950 °C et 1100 °C, afin d'activer complètement les atomes de bore. A titre d'exemple, le traitement thermique comprend un premier plateau vers 1050 °C pendant une durée t1 inférieure à 30 minutes sans oxygène, pour activer les dopants, et un deuxième plateau thermique, soit entre 800 °C et 900 °C pendant une durée t2 inférieur à 30 min sous flux d'oxygène sec, soit entre 700 °C et 800 °C (par exemple 720 °C) pendant un temps t2 inférieur à 45 min sous flux d'oxygène et de vapeur d'eau (l'oxydation humide étant plus rapide que l'oxydation sèche, elle se fait à plus basse température) pour former la couche 36b.

Les gammes de concentrations en dopants C1/C2 (ou les doses d'implantation ionique D1/D2) applicables à une cellule IBC sont sensiblement les mêmes que celles décrites pour une cellule à émetteur sélectif.

Puis, la couche d'oxyde 36b est ensuite recouverte d'une couche d'antireflet 18', pour discriminer les deux types de régions dopées 22, 24 et les motifs d'alignement 34 (étape F4). La couche antireflet 18' est, de préférence, formée du même matériau que la couche 18 recouvrant la face avant 12a exposée au rayonnement solaire, par exemple en SiN.

Enfin, des électrodes 26a et 26b sont déposées sur la couche de SiN 18', en regard respectivement des régions dopées 22 (n) et 24 (p) (étape F5). Ces électrodes sont, déposées, de préférence par sérigraphie, au travers d'un écran aligné avec le substrat grâce aux motifs 34.

En procédant ainsi, on utilise un seul masque (i.e. une seule étape d'implantation) pour délimiter à la fois les régions n et les régions p d'une cellule IBC. Cela simplifie grandement le procédé de fabrication de ces cellules, par rapport aux procédés classiques comprenant deux étapes d'implantation successives, chacune étant réalisée avec un masque différent.

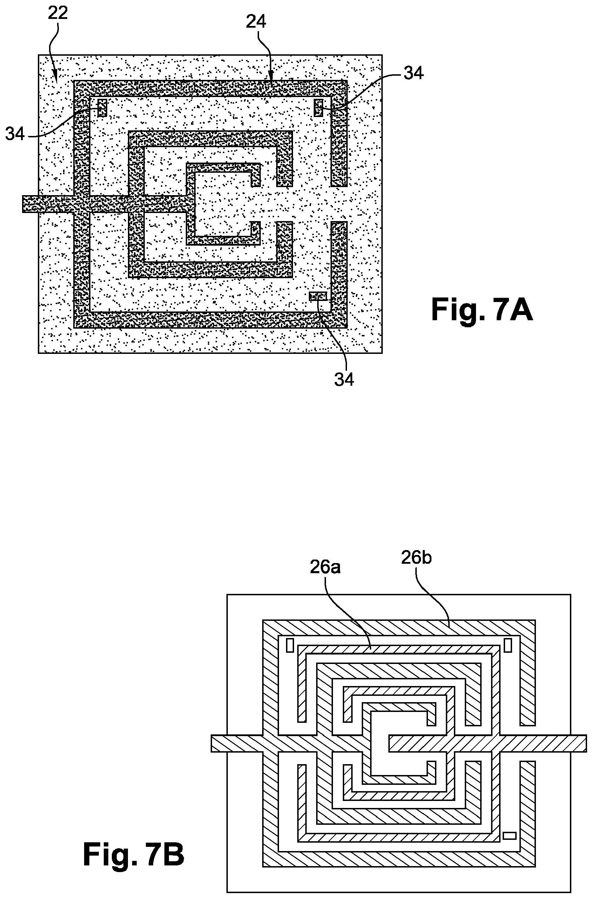

Les figures 7A et 7B représentent un autre exemple de cellule IBC en vues de dessous (face arrière), respectivement avant et après le dépôt des électrodes 26a-26b sur les régions dopées 22-24. Les pistes métalliques de chaque électrode 26a, 26b ont globalement la forme de rectangles (comme le pourtour de la cellule) et sont interconnectées. En outre, les pistes de l'électrode 26a sont inter-digitées avec celles de l'électrode 26b, de sorte que les électrodes sont imbriquées l'une dans l'autre. Trois mires d'alignement discrètes 34 sont réparties sur la surface de la cellule et formées en même temps que la région surdopée 24.

Le procédé de formation d'une cellule IBC peut comporter une étape optionnelle de nettoyage entre l'implantation F2 et le traitement thermique F3, afin d'ôter d'éventuels contaminants de surface et/ou des défauts superficiels liés à l'implantation. Cette étape est, par exemple, réalisée au moyen d'un nettoyage standard de type « SC1 » ou « SC2 ».

De nombreuses variantes et modifications du procédé de fabrication décrit ci-dessus apparaitront à l'homme du métier. En particulier, des matériaux semi-conducteurs autres que le silicium pourront servir de base à la fabrication de ces cellules photovoltaïques. Des substrats en germanium (dont l'oxyde est GeO ou $GeO_2$) ou en alliage de silicium-germanium peuvent notamment être utilisés. Les types de dopage peuvent bien sûr être inversés, en considérant par exemple un substrat de type n plutôt qu'un substrat de type p dans le cas de la cellule à émetteur sélectif (substrat de type p plutôt qu'un substrat de type n dans le cas de la cellule IBC).

Enfin, le procédé de fabrication selon l'invention n'est pas limité à des espèces chimiques de dopants en particulier, le bore et le phosphore cités plus haut étant donnés à titre d'exemple. Deux dopants d'un même type peuvent être utilisés, ensemble ou indépendamment l'un de l'autre. A titre d'exemple, le phosphore et l'arsenic peuvent être choisis pour doper deux régions distinctes d'un même type de conductivité (ex. : phosphore en région 14' et arsenic en région 14). Les ions dopants implantés peuvent être des ions composés, formés à partir de gaz précurseurs connus tels que le PH3, $AsH_3$, BF3 et B2H6, par exemple des ions phosphore hydrogéné ($PH^+$, $PH^{2+}$...) ou des ions bore fluorés ($BF^{2+}$).

**Revendications**

1. Procédé de réalisation d'une cellule photovoltaïque comprenant les étapes suivantes :

   - prévoir un substrat semi-conducteur (12) dopé d'un premier type de conductivité ;
   - former (F1) dans le substrat une première région (14, 22) dopée, la première région ayant une première concentration (C1) d'éléments dopants ;
   - former (F2), par implantation ionique d'éléments dopants dans le substrat, au moins un jeu de motifs d'alignement (34), dont la plus grande des dimensions est inférieure au millimètre, et une deuxième région (14', 24) voisine de la première région (14, 22), ayant une deuxième concentration (C2) d'éléments dopants supérieure à la première concentration (C1) ;
   - soumettre (F3) le substrat à un traitement thermique, de manière à activer les éléments dopants et à former une couche d'oxyde (36a, 36b) en surface du substrat, par-dessus les motifs d'alignement (34), la première région (14, 22) et la deuxième région (14', 24), la deuxième concentration (C2) et les conditions du traitement thermique étant choisies de sorte que la couche d'oxyde (36a) ait une épaisseur au-dessus des motifs d'alignement (34) supérieure d'au moins 10 nm à l'épaisseur de la couche d'oxyde au-dessus d'une zone du substrat adjacente aux motifs d'alignement (34) ;

- déposer (F4) une couche antireflet (18, 18') sur la couche d'oxyde ; et

- déposer (F5), au travers d'un écran (40), une électrode (16a, 26b) sur la couche antireflet, en regard de la deuxième région (14', 24), l'écran étant positionné par rapport au substrat (12) au moyen des motifs d'alignement (34).

2. Procédé selon la revendication 1, dans lequel la première concentration (C1) et les conditions de traitement thermique (F3) sont choisies de sorte que la couche d'oxyde (36a) ait une épaisseur au-dessus de la première région (14, 22) d'au moins 5 nm.

3. Procédé selon l'une des revendications 1 et 2, dans lequel la première région (14, 22) est formée par implantation ionique d'une première dose (D1) d'éléments dopants à travers toute une face du substrat (12).

4. Procédé selon la revendication 3, dans lequel la première dose (D1) est comprise entre $5.10^{14}$ cm$^{-2}$ et $2,5.10^{15}$ cm$^{-2}$ et est implantée avec une énergie d'implantation comprise entre 5 keV et 15 keV.

5. Procédé selon l'une des revendications 3 et 4, dans lequel les motifs d'alignement (34) et la deuxième région (14', 24) sont formés par implantation ionique d'une deuxième dose (D2) d'éléments dopants à travers ladite face du substrat (12) superposée d'un masque (30), d'où il résulte que les motifs d'alignement et la deuxième région cumulent les première et seconde doses (D1, D2).

6. Procédé selon la revendication 5, dans lequel la deuxième dose (D2) est comprise entre $5.10^{14}$ cm$^{-2}$ et $2,5.10^{15}$ cm$^{-2}$ et est implantée avec une énergie d'implantation comprise entre 5 keV et 15 keV.

7. Procédé selon l'une des revendications 5 et 6, dans lequel :

- la cellule photovoltaïque est une cellule photovoltaïque à émetteur sélectif ;
- ladite face du substrat (12) est une face avant (12a) de la cellule photovoltaïque ;
- la première région (14) est dopée d'un second type de conductivité opposé au premier type, de manière à former une jonction p-n ; et
- les motifs d'alignement (34) et la deuxième région (14') sont dopés du second type de conductivité.

8. Procédé selon la revendication 7, dans lequel le traitement thermique comprend une unique phase de recuit sous une atmosphère sèche comprenant de l'oxygène, à une température comprise entre 800 °C et 900 °C pendant une durée inférieure à 30 min, ou sous une atmosphère humide comprenant de l'oxygène à une température comprise entre 700 °C et 800 °C pendantune durée inférieure à une heure.

9. Procédé selon l'une des revendications 5 et 6, dans lequel :

- la cellule photovoltaïque est une cellule photovoltaïque à contacts arrières inter-digités (60) ;
- ladite face du substrat (12) est une face arrière (12b) de la cellule photovoltaïque ;
- la première région (22) est dopée du premier type de conductivité ; et
- les motifs d'alignement (34) et la deuxième région (24) sont dopés d'un second type de conductivité opposé au premier type, de manière à former une jonction p-n.

10. Procédé selon la revendication 9, dans lequel le traitement thermique comprend une première phase de recuit sans oxygène à une température comprise entre 950 °C et 1100 °C pendant une durée inférieure à 30min et une deuxième phase de recuit, soit sous une atmosphère sèche comprenant de l'oxygène à une température comprise entre 800 °C et 900 °C pendant une durée inférieure à une 30 minutes, soit sous une atmosphère humide comprenant de l'oxygène à une température comprise entre 700 °C et 800 °C pendant une durée inférieureà 45 minutes.

11. Procédé selon l'une quelconque des revendications 1 à 10, dans lequel une troisième région (15, 23) ayant le même type de conductivité que la première région (14, 22) est formée dans le substrat à l'opposé de la première région et en même temps que la première région.

12. Procédé selon la revendication 1 à 11, dans lequel l'électrode est déposée par sérigraphie et comporte une pluralité de pistes de métallisation (16a) réparties sur la couche antireflet (18).

13. Procédé selon la revendication 12, dans lequel le masque (30) comporte un premier jeu d'ouvertures (32a) correspondant à la deuxième région (14', 24), un deuxième jeu d'ouvertures (32b) correspondant aux motifs d'alignement (34) et un troisième jeu d'ouvertures (32c) correspondant à des motifs additionnels, lesdits motifs additionnels étant recouverts de plots métalliques lors de l'étape de sérigraphie et servant de mires d'alignement lors d'une étape additionnelle de sérigraphie.

**Patentansprüche**

1. Realisierungsverfahren einer photovoltaischen Zelle, umfassend die folgenden Schritte:

   - Vorsehen eines gedopten Halbleitersubstrats (12) eines ersten Leitfähigkeitstyps;
   - Bilden (F1) eines ersten gedopten Bereichs (14, 22) in dem Substrat, wobei der erste Bereich eine erste Konzentration (C1) von dopenden Elementen hat;
   - Bilden (F2) wenigstens eines Satzes von Fluchtungsmustern (34) per ionischem Einsetzen von dopenden Elementen in dem Substrat und deren größte Abmessung kleiner ist als ein Millimeter, und eines zweiten Bereichs (14', 24), der dem ersten Bereich (14, 22) benachbart ist, der eine zweite Konzentration (C2) von dopenden Elementen hat, die größer ist als die erste Konzentration (C1);
   - Unterwerfen (F3) des Substrats einer Wärmebehandlung derart, dass die dopenden Elemente aktiviert und eine Oxidschicht (36a, 36b) an der Oberfläche des Substrats oberhalb der Fluchtungsmuster (34) gebildet wird, wobei der erste Bereich (14, 22) und der zweite Bereich (14', 24), die zweite Konzentration (C2) und die Bedingungen der Wärmebehandlung derart gewählt sind, dass die Oxidschicht (36a) eine Dicke oberhalb der Fluchtungsmuster (34) hat, die um wenigstens 10 nm größer ist als die Dicke der Oxidschicht oberhalb einer Zone des den Fluchtungsmustern (34) anliegenden Substrats;
   - Aufbringen (F4) einer Antireflexschicht (18, 18') auf der Oxidschicht; und
   - Aufbringen (F5) einer Elektrode (16a, 26b) auf der Antireflexschicht gegenüber dem zweiten Bereich (14', 24) anhand einer Dachbahn (40), wobei die Dachbahn im Verhältnis zum Substrat (12) mittels der Fluchtungsmuster (34) positioniert ist.

2. Verfahren gemäß Anspruch 1, bei dem die erste Konzentration (C1) und die Bedingungen der Wärmebehandlung (F3) derart ausgewählt sind, dass die Oxidschicht (36a) eine Dicke oberhalb des ersten Bereichs (14, 22) von wenigstens 5 nm hat.

3. Verfahren gemäß irgendeinem der Ansprüche 1 und 2, bei dem der erste Bereich (14, 22) per ionischem Einsetzen einer ersten Dosis (D1) von dopenden Elementen durch eine ganze Seite des Substrats (12) gebildet ist.

4. Verfahren gemäß Anspruch 3, bei dem die erste Dosis (D1) zwischen $5.10^{14}$ cm$^{-2}$ und $2,5.10^{15}$ cm$^{-2}$ inbegriffen ist und mit einer zwischen 5 keV und 15 keV inbegriffenen Einsetzungsenergie eingesetzt ist.

5. Verfahren gemäß einem der Ansprüche 3 und 4, bei dem die Fluchtungsmuster (34) und der zweite Bereich (14', 24) per ionischem Einsetzen einer zweiten Dosis (D2) von dopenden Elementen durch die genannte Seite des einer Maske (30) überlagerten Substrats (12) gebildet sind, woraus hervorgeht, dass die Fluchtungsmuster und der zweite Bereich die erste und die zweite Dosis (D1, D2) kumulieren.

6. Verfahren gemäß Anspruch 5, bei dem die zweite Dosis (D2) zwischen $5,10^{14}$ cm$^{-2}$ und $2,5.10^{15}$ cm$^{-2}$ inbegriffen ist und mit einer zwischen 5 keV und 15 keV inbegriffenen Einsetzungsenergie eingesetzt ist.

7. Verfahren gemäß einem der Ansprüche 5 und 6, bei dem:

   - die photovoltaische Zelle eine photovoltaische Zelle mit selektivem Sender ist;
   - die genannte Seite des Substrats (12) eine vordere Seite (12a) der photovoltaischen Zelle ist;
   - der erste Bereich (14) mit einem zweiten Leitfähigkeitstyp gedopt ist, der dem ersten Typ derart gegenüberliegt, dass eine Verbindung p-n gebildet wird; und
   - die Fluchtungsmuster (34) und der zweite Bereich (14') mit dem zweiten Leitfähigkeitstyp gedopt sind.

8. Verfahren gemäß Anspruch 7, bei dem die Wärmebehandlung eine einzige Nachglüh-Phase unter einer Sauerstoff umfassenden trockenen Atmosphäre bei einer zwischen 800° C und 900° C inbegriffenen Temperatur während einer Dauer von weniger als 30 Min. oder unter einer Sauerstoff umfassenden feuchten Atmosphäre bei einer zwischen 700° C und 800° C inbegriffenen Temperatur während einer Dauer von weniger als einer Stunde umfasst.

9. Verfahren gemäß irgendeinem der Ansprüche 5 und 6, bei dem:

   - die photovoltaische Zelle eine photovoltaische Zelle mit inter-digitalisierten, hinteren Kontakten (60) ist;
   - wobei die genannte Seite des Substrats (12) eine hintere Seite (12d) der photovoltaischen Zelle ist;
   - der erste Bereich (22) mit dem ersten Leitfähigkeitstyp gedopt ist; und
   - die Fluchtungsmuster (34) und der zweite Bereich (24) mit einem dem ersten Typ entgegengesetzten zweiten Leitfähigkeitstyp derart gedopt sind, dass eine Verbindung p-n gebildet wird.

10. Verfahren gemäß Anspruch 9, bei dem die Wärmebehandlung eine erste Nachglühphase ohne Sauerstoff bei einer zwischen 950° C und 1100° C inbegriffenen Temperatur während einer Dauer von weniger als 30 Min. und einer zweiten Nachglühphase, entweder unter einer Sauerstoff umfassenden trockenen Atmosphäre bei einer zwischen 800° C und 900° C inbegriffenen Temperatur während einer Dauer von weniger als 30 Minuten, oder unter einer Sauerstoff umfassenden feuchten Atmosphäre bei einer zwischen 700° C und 800° C inbegriffenen Temperatur während einer Dauer von weniger als 45 Minuten umfasst.

11. Verfahren gemäß irgendeinem der Ansprüche 1 bis 10, bei dem ein dritter Bereich (15, 23) mit demselben Leitfähigkeitstyp wie der erste Bereich (14, 22) in dem Substrat gegenüber dem ersten Bereich und gleichzeitig mit dem ersten Bereich gebildet ist.

12. Verfahren gemäß Anspruch 1 bis 11, bei dem die Elektrode per Siebdruck aufgebracht ist und eine Vielzahl von Metallisierungsbahnen (16a) umfasst, die auf der Antireflexschicht (18) verteilt sind.

13. Verfahren gemäß Anspruch 12, bei dem die Maske (30) einen ersten Satz Öffnungen (32a) umfasst, der dem zweiten Bereich (14', 24) entspricht, wobei ein zweiter Satz Öffnungen (32b) den Fluchtungsmustern (34) entspricht und ein dritter Satz Öffnungen (32c) zusätzlichen Mustern entspricht, wobei die genannten zusätzlichen Muster bei dem Siebdruckschritt von Metallstiften abgedeckt sind und bei einem zusätzlichen Buchdruckschritt als Fluchtungsmesslatten dienen.

**Claims**

1. Method for manufacturing a photovoltaic cell comprising the following steps:

   - providing a semiconductor substrate (12) doped of a first conductivity type;
   - forming (F1) a first doped region (14, 22) in the substrate, the first region having a first concentration (C1) of doping elements;
   - forming (F2), by ion implantation of doping elements into the substrate, at least one set of alignment patterns (34), whose the largest dimension is less than a millimetre, and a second region (14', 24) neighbouring the first region (14, 22), having a second concentration (C2) of doping elements greater than the first concentration (C1);
   - subjecting (F3) the substrate to a heat treatment, so as to activate the doping elements and to form an oxide layer (36a, 36b) at the surface of the substrate, above the alignment patterns (34), the first region (14, 22) and the second region (14', 24), the second concentration (C2) and the heat treatment conditions being chosen such that the oxide layer (36a) has a thickness above the alignment patterns (34) which is at least 10 nm greater than the thickness of the oxide layer above a substrate area adjacent to the alignment patterns (34);
   - depositing (F4) an anti-reflection layer (18, 18') on the oxide layer; and
   - depositing (F5) through a screen (40) an electrode (16a, 26b) on the anti-reflection layer, facing the second region (14', 24), the screen being positioned relative to the substrate (12) using the alignment patterns (34).

2. Method according to claim 1, wherein the first concentration (C1) and the heat treatment conditions (F3) are chosen such that the oxide layer (36a) has a thickness above the first region (14, 22) of at least 5 nm.

3. Method according to one of claims 1 and 2, wherein the first region (14, 22) is formed by ion implantation of a first dose (D1) of doping elements across an entire face of the substrate (12).

4. Method according to claim 3, wherein the first dose (D1) is between $5\times10^{14}$ cm$^{-2}$ and $2.5\times10^{15}$ cm$^{-2}$, and is implanted using an implantation energy between 5 keV and 15 keV.

5. Method according to one of claims 3 and 4, wherein the alignment patterns (34) and the second region (14', 24) are formed by ion implantation of a second dose (D2) of doping elements through said face of the substrate (12) on which a mask (30) is superimposed, whereby the alignment patterns and the second region accumulate the first and second doses (D1, D2).

6. Method according to claim 5, wherein the second dose (D2) is between $5\times10^{14}$ cm$^{-2}$ and $2.5\times10^{15}$ cm$^{-2}$, and is implanted using an implantation energy between 5 keV and 15 keV.

7. Method according to one of claims 5 and 6, wherein:

   - the photovoltaic cell is a selective emitter photovoltaic cell;
   - said face of the substrate (12) is a front face (12a) of the photovoltaic cell;

- the first region (14) is doped of a second conductivity type opposite to the first type, so as to form a p-n junction; and
- the alignment patterns (34) and the second region (14') are doped of the second conductivity type.

8. Method according to claim 7, wherein the heat treatment comprises a single annealing phase in a dry atmosphere containing oxygen, at a temperature between 800 °C and 900 °C for a period of less than 30 min, or in a humid atmosphere containing oxygen at a temperature between 700 °C and 800 °C for a period of less than 1 hour.

9. Method according to one of claims 5 and 6, wherein

    - the photovoltaic cell is an interdigitated back contacts photovoltaic cell (60);
    - said face of the substrate (12) is a rear face (12b) of the photovoltaic cell;
    - the first region (22) is doped of the first conductivity type; and
    - the alignment patterns (34) and the second region (24) are doped of a second conductivity type opposite to the first type, so as to form a p-n junction.

10. Method according to claim 9, wherein the heat treatment comprises a first annealing phase without oxygen at a temperature between 950 °C and 1100 °C for a period of less than 30min and a second annealing phase, either in a dry atmosphere containing oxygen at a temperature between 800 °C and 900 °C for a period of less than 30 minutes, or in a humid atmosphere containing oxygen at a temperature between 700 °C and 800 °C for a period of less than 45 minutes.

11. Method according to any of claims 1 to 10, wherein a third region (15, 23) having the same conductivity type as the first region (14, 22) is formed in the substrate on the opposite side to the first region and at the same time as the first region.

12. Method according to claim 1 to 11, wherein the electrode is deposited by screen-printing and comprises a plurality of metallisation tracks (16a) distributed over the anti-reflection layer (18).

13. Method according to claim 12, wherein the mask (30) comprises a first set of openings (32a) corresponding to the second region (14', 24), a second set of openings (32b) corresponding to the alignment patterns (34) and a third set of openings (32c) corresponding to additional patterns, said additional patterns being covered with metal studs during the screen-printing step and acting as alignment marks during an additional screen-printing step.

**Fig. 1A**
(Art antérieur)

**Fig. 1B**
(Art antérieur)

**Fig. 2A**
(Art antérieur)

**Fig. 2B**
(Art antérieur)

**Fig. 3A**

**Fig. 3B**

**Fig. 3C**

**Fig. 3D**

Fig. 3E

Fig. 4

# Fig. 5A

# Fig. 5B

# Fig. 6

**Fig. 7A**

**Fig. 7B**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20110139230 A

**Littérature non-brevet citée dans la description**

- **C. E. DUBÉ et al.** High efficiency selective emitter cells using patterned ion implantation. *Energy Procedia,* 2011, vol. 8, 706-711